# EUROPEAN PATENT SPECIFICATION

(11) **EP 4 283 319 B1**
(45) Date of publication and mention of the grant of the patent: **25.11.2026**
(21) Application number: 23742172.2
(22) Date of filing: 25.01.2023
(51) Int. Cl.: G01R 31/367, G01R 31/392, G01R 31/36, G01R 31/396, G01R 31/3842, B60L 58/16, B60L 3/12, B60L 3/00, B60L 58/12

(54) **DEVICE AND METHOD FOR PREDICTING DEFECTIVE RATE OF BATTERIES**
VORRICHTUNG UND VERFAHREN ZUR VORHERSAGE DER DEFEKTRATE VON BATTERIEN
DISPOSITIF ET PROCÉDÉ DE PRÉDICTION DE TAUX DÉFECTUEUX DE BATTERIES

(30) Priority: 11.04.2022 KR 20220044656
(43) Date of publication of application: 29.11.2023
(73) Proprietor: LG ENERGY SOLUTION, LTD., Seoul 07335 (KR)
(72) Inventor: RYU, Hojin, Daejeon 34122 (KR)
(74) Representative: Goddar, Heinz J.
(86) International application number: PCT/KR2023/001136
(87) International publication number: WO 2023/200087

(56) References cited:
- WO-A1-2021/141255
- WO-A1-2021/246788
- CN-A- 114 072 684
- KR-A- 20150 120 697
- KR-A- 20160 017 416
- KR-A- 20170 011 010
- KR-A- 20170 022 746
- KR-A- 20210 089 021
- US-A1- 2013 090 900

## Description

### [Technical Field]

### CROSS-REFERENCE TO RELATED APPLICATION

This application claims priority to and the benefit of Korean Patent Application No. 10-2022-0044656 filed in the Korean Intellectual Property Office on April 11, 2022.

The present disclosure relates to an apparatus and a method of predicting a failure rate for a battery.

### [Background Art]

Long life and minimized failure rates are the primary concerns of automobile companies interested in electric vehicle batteries. This is because long life and minimized failure rates are quality factors that are directly related to the warranty period of an electric vehicle, and automobile companies may analyze the life degradation of key vehicle components and use long life and minimized failure rates to communicate warranty period and mileage information to potential end-users. In order to predict the life degradation of vehicle components, automobile companies are utilizing statistical analysis methodology for determining the failure rate, which has a result value in the unit of PPM(parts per million), in conjunction with simulation.

It is important to note that the prerequisites for determining the failure rate are based on many years of experience in reliability analysis of vehicle components. While most of the vehicle components of an existing internal combustion engine vehicle consist of mechanical devices including the engine, the core component of an electric vehicle is the battery, which is the main power source and the main quality factor to replace the internal combustion engine. Therefore, the existing statistical methodology for mechanical reliability analysis is limited in its application to electric vehicle batteries having electrochemical properties.

WO 2021/141255 A1 discloses an IoT device which conducts an experiment on a battery pack including multiple battery cells by using at least one experimental device, and, in the experiment, receives an input and an output of the at least one experimental device and pre-processes the input and the output to generate input data and output data; an edge computing device for predicting information required to predict capacity degradation values of the multiple battery cells, by using an equivalent circuit model module and a thermal model module on the basis of received data among the input data and the output data; and a server which receives the predicted information from the edge computing device, predicts capacity degradation values of the multiple battery cells by using an aging model module, and predicts a failure rate on the basis of the predicted capacity degradation values. Each size of the input data and the output data transferred to the edge computing device from the IoT device may be smaller than a predetermined size of data.

US 2013/090900 A1 discloses a method, system, and computerreadable medium for characterizing performance loss of an object undergoing an arbitrary aging condition. The method comprises collecting baseline aging data from the object for at least one known baseline aging condition over time, determining baseline multiple sigmoid model parameters from the baseline data, and determining performance loss data of the object over time through multiple sigmoid model parameters associated with the object undergoing the arbitrary aging condition using a differential deviation-from-baseline approach from the baseline multiple sigmoid model parameters. The system comprises an object, monitoring hardware configured to sample performance characteristics of the object, and a processor coupled to the monitoring hardware. The processor is configured to determine performance loss data for the arbitrary aging condition from a comparison of the performance characteristics of the object deviating from baseline performance characteristics associated with a baseline aging condition.

### [Disclosure]

### [Technical Problem]

The present invention provides an apparatus and a method of predicting a failure rate of a battery based on capacity fade data of the battery predicted through aging simulation.

### [Technical Solution]

The invention is set out in the appended claims. An apparatus for predicting a failure rate according to one characteristic of the present invention includes: a data generation device for restoring and extracting at least two driving profiles by allowing duplication among a plurality of driving profiles configuring original data, generating a plurality of extended driving profiles by combining the at least two extracted driving profiles, and generating a plurality of extended weights corresponding to the plurality of extended driving profiles; an aging simulation device for generating a plurality of capacity fades by performing a life analysis simulation to which a plurality of climate conditions are applied on the plurality of extended driving profiles; and a PPM simulation device for generating a plurality of probability weights based on the plurality of extended weights and weights corresponding to the plurality of climate conditions, and for calculating a PPM value based on the plurality of capacity fades and the plurality of probability weights.

The aging simulation device may include: an ECM module for applying each of the plurality of extended driving profiles to an electrical Equivalent Circuit Model (ECM) for a battery subject to an aging simulation to generate a voltage, a current, an SOC, a C-rate, and an amount of heating of the battery corresponding to each of the extended driving profiles; a thermal model module for generating an average temperature of a battery by using the amount of heating of the corresponding battery and a temperature of each of the extended driving profiles, for each of the plurality of extended driving profiles; and an aging model module for calculating a capacity fade of the battery based on the voltage, the current, the SOC, the C-rate, a driving mode, an average temperature, and the number of cells of the corresponding battery, for each of the plurality of extended driving profiles.

The aging model module may calculate a capacity fade by separating a cycle degradation due to a driving pattern by discharging and charging due to driving in the driving mode and a calendar degradation due to a rest state of the battery in the driving mode.

The PPM simulation device may assign, for each of the plurality of capacity fades, a corresponding probability weight among the plurality of probability weights, bootstrap based on the plurality of probability weights assigned to the plurality of capacity fades, and calculate a PPM value for sample data extracted by the bootstrapping.

The PPM simulation device may include a probability weight generation unit for generating the plurality of probability weights by using a result of multiplying the plurality of extended weights and a weight of each of the plurality of climate conditions.

The probability weight generation unit may multiply the plurality of extended weights by the weight of each of the plurality of climate conditions to generate a plurality of composite weights, and for each of the plurality of climate conditions, calculate a weight sum by adding all of the plurality of composite weights belonging to each climate condition, and calculate a probability weight by dividing each of the plurality of composite weights belonging to each climate condition by the weight sum.

The PPM simulation device may include a PPM derivation unit which assigns each of the plurality of probability weights to a corresponding capacity fade among the plurality of capacity fades, and repeats bootstrapping a predetermined number of times to restore and extract a predetermined number of capacity fades among the plurality of capacity fades based on the plurality of probability weights assigned to the plurality of capacity fades.

The PPM derivation unit may calculate a PPM value by applying at least one probability distribution model to the predetermined number of capacity fades extracted from each bootstrapping, and generate a final PPM value by adding PPM values derived from the predetermined number of times of the bootstrapping.

The PPM simulation device may extract a plurality of capacity fades based on the plurality of probability weights for the plurality of capacity fades, perform a plurality of PPM simulations by applying a plurality of probability distribution models to the plurality of extracted capacity fades, and determine at least one probability distribution model by applying at least one statistical modeling index to the plurality of PPM simulation results.

A method of predicting a failure rate according to another characteristic of the present invention includes: restoring and extracting at least two driving profiles by allowing duplication among a plurality of driving profiles configuring original data, and generating a plurality of extended driving profiles by combining the at least two extracted driving profiles; generating a plurality of extended weights corresponding to the plurality of extended driving profiles; generating a plurality of capacity fades by performing a life analysis simulation to which a plurality of climate conditions are applied on the plurality of extended driving profiles; generating a plurality of probability weights based on the plurality of extended weights and weights corresponding to the plurality of climate conditions; and calculating a final PPM value by assigning the plurality of probability weights to the plurality of capacity fades .

The calculating of the final PPM value may include: assigning, for each of the plurality of capacity fades, a corresponding probability weight among the plurality of probability weights; bootstrapping based on the plurality of probability weights assigned to the plurality of capacity fades; and calculating a PPM value for sample data extracted by the bootstrapping.

The bootstrapping may include restoring and extracting a predetermined number of capacity fades among the plurality of capacity fades based on the plurality of probability weights assigned to the plurality of capacity fades.

The calculating of the PPM value may include calculating a PPM value by applying at least one probability distribution model to the predetermined number of capacity fades extracted from the bootstrapping.

The calculating of the final PPM value may further include generating a final PPM value by adding PPM values derived from the predetermined number of times of bootstrapping.

The generating of the plurality of probability weights may include: multiplying the plurality of extended weights by the weight of each of the plurality of climate conditions to generate a plurality of composite weights; for each of the plurality of climate conditions, calculating a weight sum by adding all of the plurality of composite weights belonging to each climate condition; and calculating a probability weight by dividing each of the plurality of composite weights belonging to each climate condition by the weight sum.

The method may further include: extracting a plurality of capacity fades based on the plurality of probability weights for the plurality of capacity fades; performing a plurality of PPM simulations by applying a plurality of probability distribution models to the plurality of extracted capacity fades; and determining at least one probability distribution model by applying at least one statistical modeling index to the plurality of PPM simulation results.

### [Advantageous Effects]

The present invention provides an apparatus and a method of predicting a failure rate of a battery based on capacity fade data of the battery predicted through aging simulation.

### [Description of the Drawings]

FIG. 1 is a diagram illustrating a failure rate predicting apparatus according to an exemplary embodiment.
FIG. 2 is a block diagram illustrating an aging simulation device according to the exemplary embodiment.
FIG. 3 is a diagram illustrating a PPM simulation device according to the exemplary embodiment.
FIG. 4 is a diagram illustrating a PPM simulation device according to the exemplary embodiment.
FIG. 5 is a graph illustrating a cumulative distribution function for a plurality of capacity fades and cumulative distribution functions for three probability distribution models with excellent goodness of model fit according to the exemplary embodiment.
Each of FIGS. 6 to 8 is a diagram illustrating a visualization result of a cumulative distribution function and a histogram-based probability density function for three probability denominator models according to the exemplary embodiment.
FIGS. 9 to 11 are diagram illustrating the results of applying three probability denominator models to a plurality of capacity fades derived from bootstrapping based on probability weights.
FIG. 12 is a table representing the PPM values for each model derived for each bootstrapping count.

### [Mode for Invention]

Hereinafter, an exemplary embodiment disclosed the present specification will be described in detail with reference to the accompanying drawings, and the same or similar constituent element is denoted by the same reference numeral regardless of a reference numeral, and a repeated description thereof will be omitted. Suffixes, "module" and/or "unit" for a constituent element used for the description below are given or mixed in consideration of only easiness of the writing of the specification, and the suffix itself does not have a discriminated meaning or role. Further, in describing the exemplary embodiment disclosed in the present disclosure, when it is determined that detailed description relating to well-known functions or configurations may make the subject matter of the exemplary embodiment disclosed in the present disclosure unnecessarily ambiguous, the detailed description will be omitted. Further, the accompanying drawings are provided for helping to easily understand exemplary embodiments disclosed in the present specification, and it will be appreciated that the present invention includes all of the modifications, equivalent matters, and substitutes included in the technical scope of the present invention.

Terms including an ordinary number, such as first and second, are used for describing various constituent elements, but the constituent elements are not limited by the terms. The terms are used only to discriminate one constituent element from another constituent element.

It should be understood that when one constituent element is referred to as being "coupled to" or "connected to" another constituent element, one constituent element can be directly coupled to or connected to the other constituent element, but intervening elements may also be present. By contrast, when one constituent element is referred to as being "directly coupled to" or "directly connected to" another constituent element, it should be understood that there are no intervening elements.

In the present application, it will be appreciated that terms "including" and "having" are intended to designate the existence of characteristics, numbers, steps, operations, constituent elements, and components described in the specification or a combination thereof, and do not exclude a possibility of the existence or addition of one or more other characteristics, numbers, steps, operations, constituent elements, and components, or a combination thereof in advance.

In the following description, "cell" refers to a battery cell configuring a battery pack, and a battery may include at least one battery pack.

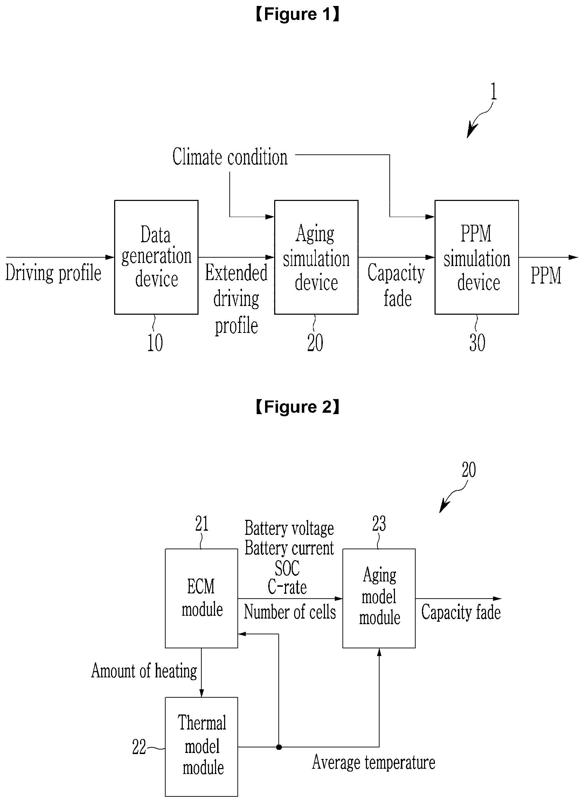

FIG. 1 is a diagram illustrating a failure rate predicting apparatus according to an exemplary embodiment.

As illustrated in FIG. 1, a failure rate predicting apparatus 1 includes a data generating device 10, an aging simulation device 20, and a PPM simulation device 30.

The data generating device 10 may generate input data having a data distribution of more types than the data distribution of the original data by combining driving profiles that are original data.

An driving profile for battery life analysis may include power values, temperature, and a driving mode. Power is a value (in Watt) for the battery power sampled at a predetermined sampling time interval, temperature is a value in a predetermined unit for the temperature conditions recorded over a predetermined period of time, and a driving mode means a driving state of the vehicle. The driving mode may be defined by three driving patterns, for example, a driving mode may include a driving/discharging mode, a charging mode, and a parking/rest mode. In the driving profile, the driving pattern is configured to synchronize with the power value of the battery, which can be defined as a driving pattern value of 2 for a - sign (discharge), 1 for a + sign (charge), and 0 for parking, depending on the direction and value of the power. The temperature value and the driving pattern value may be values acquired at the same sampling interval as the power value.

The data generating device 10 may restore and extract at least two driving profiles from a plurality (Na, a natural number of 2 or more) of driving profiles configuring the original data, and generate a plurality (Nb, a natural number of 2 or more) of driving profiles (hereinafter, an extended driving profile) by combining the extracted at least two driving profiles. Hereafter, for convenience of explanation, the number of driving profiles to be restored and extracted from the plurality of driving profiles is described as 2, and Na may be 30, and Nb may be 900. However, the present invention is not limited thereto.

The data generating device 10 may select two driving profiles by allowing duplication among the 30 driving profiles, and add the two selected driving profiles together to generate a total number of combinations 900 (=30×30) of extended driving profiles. This solves the problem that the original data of 30 driving profiles does not sufficiently describe the driving patterns of the population.

For example, a plurality of driving profiles input to the data generating device 10 may be divided into two groups according to regions, and includes 15 driving profiles A1, A2, A3, ..., and A15 for region A and 15 driving profiles B1, B2, B3, ..., and B15 for region B, and each driving profile may consist of about one month (30 days) of power value-based driving pattern data. Each of the 900 extended driving profiles C1, C2, C3, ..., and C900 generated by the data generating device 10 is generated by adding two corresponding driving profiles as follows.
C1=A1+A1, ..., C30=A1+B15,
C31=A2+A1, ..., C60=A2+B15,
   **............**
C421=A15+A1, ..., C450=A15+B15,
C451=B1+A1, ..., C480=B1+B15,
   **............**
C871=B15+A1, ..., C900=B15+B15

The extended driving profile (for example, C451) with the two driving profiles added as described above includes a total of 60days of power values in which 30 days of power values from the first profile (for example, A15) used in the combination is followed by 30 days of power values from the second profile (for example, A1) used in the combination.

The data generating device 10 may generate a weight (hereinafter, referred to as extended weights) corresponding to each of the plurality of extended driving profiles. For example, the data generating device 10 may multiply the weights of two driving profiles of the original data that configure one of the generated 1800 extended driving profiles to generate a corresponding extended weight.

The aging simulation device 20 may generate a plurality of capacity fades by performing life analysis simulations to which Nc (a natural number of 2 or more) climate conditions are applied on the plurality of extended driving profiles. The aging simulation device 20 may generate a plurality of (Nb × Nc) capacity fades, in which each of the plurality of capacity fades may be a capacity fade for the corresponding one of the plurality of climate conditions and the corresponding one of the plurality of extended driving profiles. Hereafter, for simplicity, Nc will be described as 2. For example, the aging simulation device 20 may life-analysis simulate the 900 extended driving profiles under two climate conditions to generate a total of 1800 capacity fades.

FIG. 2 is a block diagram illustrating the aging simulation device according to the exemplary embodiment.

The aging simulation device 20 includes an equivalent circuit model (ECM) module 21, a thermal model module 22, and an aging model module 23.

The ECM module 21 may apply each of the plurality of extended driving profiles to the ECM to generate battery operation information based on the driving, and generate a plurality of battery operation information for the plurality of extended driving profiles. The ECM is an electrical equivalent circuit model for the battery that is a target for the aging simulation, and may be implemented by modeling the internal parameters of the battery as an electrical circuit. Input parameters required by the ECM according to the exemplary embodiment may include a power value, an initial State of Charge (SOC), an average temperature, a number of cells configuring the battery, a driving mode, an initial Open Circuit Voltage (OCV), and a cell capacity. The power value and the driving mode may be obtained from the extended driving profile, and the average temperature may be received from the thermal model module 22.

The ECM module 21 may derive the battery cell current based on the power value recorded in the extended driving profile. The ECM module 21 may accumulate battery cell currents and estimate a current SOC value based on the initial SOC value, the battery cell capacity, and the results of the current accumulation. For example, the ECM module 21 may estimate the current SOC by adding the SOC change amount obtained by dividing the result of the accumulation of the current battery cell currents in unit time based on the power value by the battery cell capacity to a previous SOC. The initial SOC value required for the first operation to estimate the SOC value may be set as an input parameter. The ECM module 21 may determine the battery current by considering the connection relationship between the battery cells configuring the battery to the battery cell current. For example, when all the battery cells configuring the battery are connected in series, the battery current may be equal to the battery cell current. Alternatively, when the battery cells are connected in series in the unit of two cells connected in parallel, the battery current may be a value obtained by multiplying the battery cell current by two.

The ECM module 21 may determine the SOC of one battery cell as the SOC of the battery by assuming that all cells configuring the battery have the same characteristics.

The ECM module 21 may estimate an OCV of the battery cell and the both-end voltages of the battery cell (hereinafter, the battery cell voltage) based on the RC equivalent circuit corresponding to the battery cell. Specifically, the ECM module 21 may determine the OCV voltage corresponding to the current SOC, calculate a series resistance voltage when the battery cell current flows through a series resistor in the RC equivalent circuit and a polarization resistance voltage when the battery cell current flows through a polarization resistor in the RC equivalent circuit, and calculate the battery cell voltage by adding the OCV voltage, the series resistance voltage, and the polarization resistance voltage. The ECM module 21 may determine the battery voltage by considering the connection relationship between the battery cells configuring the battery to the battery cell voltage. For example, when all the cells configuring the battery are connected in series, the ECM module 21 may calculate the battery voltage by multiplying the battery cell voltage by the number of battery cells.

The ECM module 21 may calculate a C-rate based on the battery cell current. The C-rate (charge and discharge rate) is a percentage of the current value used to charge and discharge the battery. The ECM module 21 may calculate a C-rate by dividing the battery cell current by the battery cell capacity.

The ECM module 21 may calculate the amount of heating of the battery by considering the battery cell current, the cell voltage, the average temperature, and the number of cells. The average temperature may be received from the thermal model module 22. The amount of heating may be input to the thermal model module 22 and the aging model module 23. The average temperature is used as an important input value that affects key battery parameters in the RC model-based ECM model. In actual, it can be confirmed that as the temperature increases, the electrochemical reaction inside the battery is activated and the internal resistance decreases, and as the temperature decreases, the internal resistance increases. This can affect not only the availability of the battery's voltage region, but also the SOH, that is, capacity fade.

The thermal model module 22 may generate an average temperature of the battery in the vehicle by using the amount of heating and the temperature of each extended driving profile received from the ECM module 21, for each of the plurality of extended driving profiles. The thermal model module 22 may generate an average temperature by considering parameters, such as the amount of heat of air considering the structure of the vehicle interior, along with the amount of heating and the temperature. To this end, the thermal model module 22 may receive inputs, such as a cooling reference temperature and a thermal resistance coefficient of the battery. The cooling reference temperature may be a reference temperature value to proceed with cooling when the temperature of the battery reaches a certain level. The temperature in the extended driving profile may be the temperature outside the vehicle, which reflects the climate conditions of the region in which the vehicle operated. The thermal model module 22 may consider the thermal resistance coefficient of the battery along with the amount of coolant in order to determine the influence of the amount of heat transferred to the air on the temperature of the battery. The thermal model module 22 may calculate an average temperature value generated in the battery in consideration of the amount of heat of the battery, whether cooling is in progress based on the cooling reference temperature, and the amount of heat transferred to the battery by the air.

For each of the plurality of extended driving profiles, the aging model module 23 may receive the battery voltage, the battery current, the SOC, the C-rate, the driving mode, the average temperature, and the number of cells, and calculate the capacity fade of the battery. The aging model module 23 may calculate a life analysis value of the battery according to the capacity fade, and may also calculate the power value of the battery, the power value of a single cell, and the energy throughput of the battery according to the power value based on the battery voltage, the battery current, and the number of cells. The aging model module 23 may derive an SOH value, that is, a capacity retention value of the battery, by applying the power value, the energy throughput, the average temperature, the C-rate, and the SOC of the battery to an algorithmic formula that reflects a fade curve equation. Battery temperature and charging/discharging are important factors in determining the degree of battery degradation. The fade curve may be obtained through actual battery fade experiments.

The aging model module 23 may determine the capacity fade based on the specific operational state of the battery, taking into account the driving mode. For example, in the operation process of an electric vehicle, driving corresponds to the discharge of the battery, and the fade caused by the driving pattern consisting of discharge and charge by driving in the driving mode may be defined as cycle degradation. Another pattern in the driving mode is the parking mode of the electric vehicle, which is the rest state of the battery, and the fade from the rest state may be defined as calendar degradation. In the cycle degradation, the battery is repeatedly charged and discharged to accelerate the capacity fade of the battery, and in the Calenda fade, the battery is minimally used, so that the capacity of the battery naturally fades. The aging model module 23 may calculate the capacity fade by dividing the fade process of the battery into one of the above two types in the driving mode. The method in which the aging model module 23 calculates capacity fade is not limited to those described above, and may be implemented in publicly known various methods.

The aging model module 23 may also calculate a degree of capacity retention based on the capacity fade. For example, when it is assumed that the initial capacity of the battery is 100%, the aging model module 23 may subtract the capacity fade from 100% to calculate the degree of capacity retention. The aging model module 23 may also derive the degree of resistance increase of the battery based on an algorithm in which the capacity fade curve equation is reflected.

The ECM module 21, the thermal model module 22, and the aging model module 23 described thus far are exemplary embodiments, and the invention is not limited thereto. For example, since the aging model module 23 may be implemented variously for each battery manufacturing company, and the required input parameters may vary depending on the aging model module, the ECM module and the thermal model module may also be appropriately designed to provide input parameters for the aging model module.

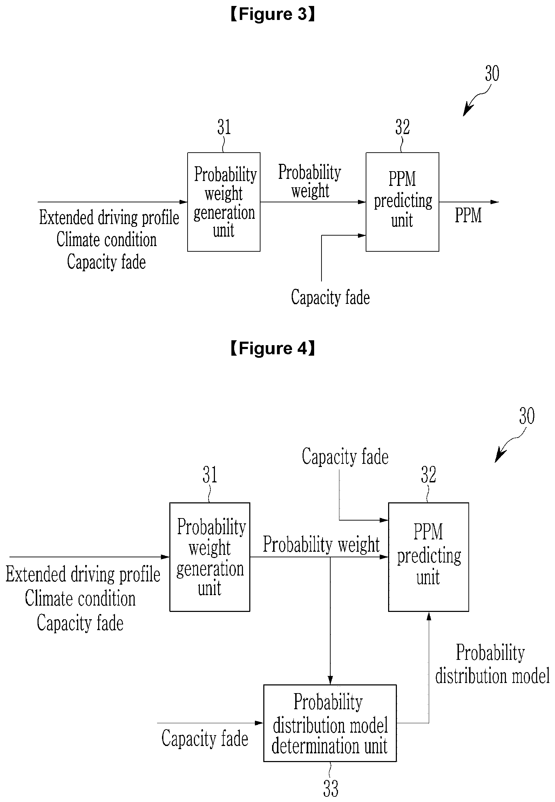

Hereinafter, the PPM simulation device will be described with reference to FIG. 3.

FIG. 3 is a diagram illustrating a PPM simulation device according to the exemplary embodiment.

The PPM simulation device 30 may generate a plurality of probability weights based on a plurality of extended weights and weights corresponding to the plurality of climate conditions, and calculate a PPM value based on the plurality of capacity fades and the plurality of probability weights. The PPM simulation device 30 may assigns a corresponding probability weight among the plurality of probability weights to each of the plurality of capacity fades, bootstrap according to the plurality of probability weights assigned to the plurality of capacity fades, and calculate a PPM value for the sample data extracted by the bootstrapping.

The PPM simulation device 30 may receive input of the plurality of extended driving profiles and the plurality of climate conditions, and the plurality of capacity fades corresponding to the plurality of extended driving profiles and the plurality of climate conditions. The PPM simulation device 30 may receive the extended driving profile along with a file name, extended weights, and driving period.

The filename is a name that refers to each of the plurality of extended driving profiles. If the 900 extended driving profiles are named C1 to C900, each of the 900 extended driving profiles may be subject to two climate conditions, such as Climate Condition 1 (C1, ..., C451, ..., and C900) and Climate Condition 2 (C1, ..., C451, ..., and C900).

The driving period may refer to the amount of time it takes to reach the target mileage for each driving profile. For example, when the driving profile for A1 is a driving record for 30 days, and the same driving record is repeated 100 times, it may be defined to reach the target mileage of 160,000 kilometers in about 8 years. In this case, the numerical value of 8 years is the driving period of the A1 profile. This may be expressed as A1 (8 years), A2 (10 years), A3 (4 years), ..., and A15 (13 years).

The PPM simulation device 30 may include a probability weight generation unit 31 and a PPM prediction unit 32.

The probability weight generation unit 31 may generate a plurality of probability weights by using the result of multiplying the plurality of extended weights by the weight of each of the plurality of climate conditions. First, the probability weight generation unit 31 may generate a plurality of composite weights by multiplying the plurality of extended weights by the weight of each of the plurality of climate conditions. The probability weight generation unit 31 may generate 900 composite weights by multiplying the 900 extended driving profiles by the weight of each of the two climate conditions.

The respective weights of the 15 driving profiles in Region A are A1(wa1), A2(wa2), A3(wa3), A4(wa4), ..., and A15(wa15), and the respective weights of the 15 driving profiles in Region B are B1(wb1), B2(wb2), B3(wb3), B4(wb4), ..., and B15(wb15), the extended weight of each extended driving profile may be represented as the product of the weights of the corresponding two driving profiles. The probability weight generation unit 31 may multiply the weight (cc1, cc2) of the corresponding climate condition between climate conditions 1 and 2 by the extended weight to calculate a composite weight. The composite weights of the 900 extended driving profiles for climate condition 1 are, cc1*wa1*wa1, ..., cc1*wa1*wb15, cc1*wa2*wa1, ... , cc1*wa2*wb15, ..., cc1*wa15*wa1, ..., cc1*wa15*wb15, cc1*wb1*wa1, ..., cc1*wb1*wb15, ..., cc1*wb15*wa1, ..., cc1*wb15*wb15, and the composite weights of the 900 extended driving profiles for climate condition 2 are, cc2*wa1*wa1, ..., cc2*wa1*wb15, cc2*wa2*wa1, ... , cc2*wa2*wb15,..., cc2*wa15*wa1, ..., cc2*wa15*wb15, cc2*wb1*wa1, ..., cc2*wb1*wb15, ..., cc2*wb15*wa1, ..., and cc2*wb15*wb15.

The above calculation of the composite weight is an example according to the exemplary embodiment, and the invention is not limited thereto. Any calculation method that can generate a corresponding weight based on the distribution of the population may be applicable in the exemplary embodiment.

For each of the plurality of climate conditions, the probability weight generation unit 31 may calculate a weight sum by adding all of the plurality of composite weights belonging to each climate condition, and calculate a probability weight by dividing each of the plurality of composite weights belonging to each climate condition by the weight sum.

For example, the probability weight generation unit 31 may divide each of the 900 composite weights for climate condition 1 as represented in Equation 2 by the value (TW1) obtained by summing all 900 composite weights for climate condition 1 as represented in Equation 1 to calculate 900 probability weights CW1 to CW900 belonging to climate condition 1. [Equation 1] 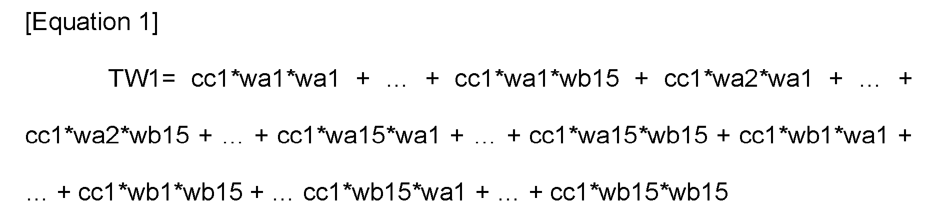 TW1= cc1*wa1*wa1 + ... + cc1*wa1*wb15 + cc1*wa2*wa1 + ... + cc1*wa2*wb15 + ... + cc1*wa15*wa1 + ... + cc1*wa15*wb15 + cc1*wb1*wa1 + ... + cc1*wb1*wb15 + ... cc1*wb15*wa1 + ... + cc1*wb15*wb15 [Equation 2] $CW 1 = cc 1 * wa 1 * wa 1 / TW 1 , … CW 900 = cc 1 * wb 15 * wb 15 / TW 1$

The probability weight generation unit 31 may divide each of the 900 composite weights for climate condition 2 as represented in Equation 4 by the value (TW2) obtained by summing all 900 composite weights for climate condition 2 as represented in Equation 3 to calculate 900 probability weights CW901 to CW1800 belonging to climate condition 2. [Equation 3] 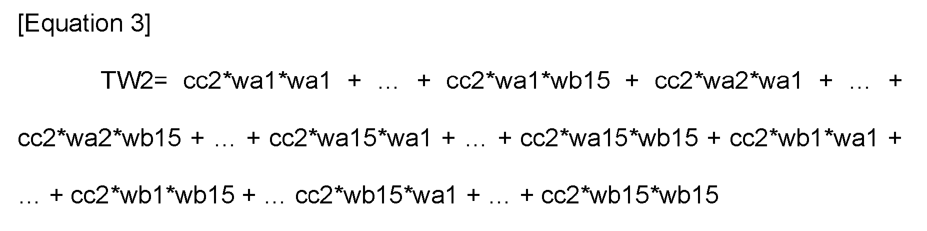 TW2= cc2*wa1*wa1 + ... + cc2*wa1*wb15 + cc2*wa2*wa1 + ... + cc2*wa2*wb15 + ... + cc2*wa15*wa1 + ... + cc2*wa15*wb15 + cc2*wb1*wa1 + ... + cc2*wb1*wb15 + ... cc2*wb15*wa1 + ... + cc2*wb15*wb15 [Equation 4] $CW 901 = cc 2 * wa 1 * wa 1 / TW 1 , … CW 1800 = cc 2 * wb 15 * wb 15 / TW 2$

The sum of the 900 probability weights belonging to each group is 1 as represented in Equation 5. [Equation 5] $1 = CW 1 + … + CW 900,1 = CW 901 + … + CW 1800$

The PPM prediction unit 32 may assign each of the plurality of probability weights to a corresponding capacity fade among the plurality of capacity fades and repeat an operation (hereinafter, bootstrapping) of restoring and extracting a predetermined number (Nr) of capacity fades among the plurality of capacity fades according to the plurality of probability weights assigned to the plurality of capacity fades a predetermined number (Nn) of times. A corresponding probability weight is pre-assigned to each of the plurality of capacity fades, the assigned weight is redefined by a probability numerical value based on the proportion in the total number of capacity fades, and the corresponding capacity fade is re-extracted based on the probability numerical values in the bootstrapping process, so that the accuracy of PPM result may be improved.

For example, the PPM prediction unit 32 may assign each of the 1,800 probability weights to the corresponding capacity fade among the 1,800 capacity fades. The PPM prediction unit 32 may restore and extract 1,800 capacity fades among the 1,800 capacity fades according to the plurality of probability weights in each bootstrapping. The PPM prediction unit 32 may repeat the bootstrapping 30 times. As described above, the probability weights are pre-assigned to the corresponding capacity fades, so that the capacity fade may be randomly extracted according to the probability weight.

The PPM prediction unit 32 may calculate a PPM value by applying at least one probability distribution model to a predetermined number (Nr) of capacity fades extracted in each bootstrapping. The PPM prediction unit 32 may add the PPM values derived from the predetermined number of times (Nn) of the bootstrapping to generate a final PPM value (hereinafter, the final PPM value). In this case, in order to determine at least one probability distribution model, statistical modeling may be used.

First, a method of determining the probability distribution model utilized by the PPM prediction unit 32 will be described.

Statistical modeling may be used as an indicator of goodness of fit of various probability distribution models. Through statistical modeling, a balanced probability distribution model may be selected by avoiding the overfitting and underfitting problems that occur in the process of fitting data and models.

In order to determine the probability distribution model used by the exemplary embodiment, statistical modeling uses indexes, such as Negative Log Likelihood (NLL), Akaike Information Criteria (AIC), AIC correction (AICc), Bayesian Information Criteria (BIC), and Root Mean Square Error (RMSE).

NLL is an index used in a method called Maximum Likelihood Estimation (MLE), which is used to statistically determine whether actual data matches a probability distribution model. The method of calculating NLL is represented in Equation 6. [Equation 6] $NLL = - ln \left(L\right) = - ln \left({\prod }_{i = 1}^{n} {f}_{k} \left({x}_{i}\left|θ\right.\right)\right)$

In Equation 6, L means a likelihood function, which matches the formula in square brackets in the rightmost formula and has the following meaning. fk(xi|θ) is a probability density function, and a result value obtained by multiplying (Q) all the probability values obtained by applying the parameter θ, in which i is a numerical value from 1 to the number n of data. It is the process of maximizing the resulting value L, that is, the likelihood function, through the parameter 8. By taking the logarithm of the value of L and applying a negative sign, -ln(L) is obtained, which in turn becomes NLL. Therefore, maximizing of the value of L is minimizing NLL, and a minimized NLL value means that goodness of fit of the probability distribution model to the actual data is high. However, it has the limitation that there is a risk of overfitting when the actual number of data is smaller than the number of parameters of the probability distribution model.

AIC is one of the statistical modeling indexes using the likelihood function, identically to the NLL introduced earlier. The method of calculating AIC is represented in Equation 7. [equation 7] $AIC = - 2 ⋅ ln \left(L\right) + 2 ⋅ k$

In Equation 7, L is the likelihood function, and as the goodness of fit is higher, the value of L is larger, and as the logarithmic value of ln(L) is larger, the value of -2ln(L) is smaller. Herein, k is the number of parameters in the model to be fitted with AIC, is also known as an independent variable. In other words, the value of k increases as the complexity of the model increases and the number of independent variables to fit increases, and this adds the numerical value when the value of -2ln(L) is decreased as the goodness of model fit is higher, so that k may be considered to serve as a penalty to prevent overfitting. When the number of actual data increases, the value of L increases and the AIC value is less affected by the penalty, so that it is possible to accurately predict the distribution of a population.

AICc is one of statistical modeling indexes in which bias of the AIC is corrected. In contrast to AIC, AICc is more predictive power when the number of data is relatively limited and is little. The method of calculating AIC is represented in Equation 8. [Equation 8] $AICc = AIC + \frac{2 k ⋅ \left(k+1\right)}{n - k - 1}$

Equation 8 uses the AIC as a framework, but adds 2k(k+1)/n-k-1 as a correction term. Same as AIC, k is the number of independent variables and n is the number of data. In this case, as the value of n, that is, the number of data, increases infinitely, the performance difference between AIC and AICc disappears. As can be seen from the Equation, the principle of AIC is used as it is, so that as the value of AICc is smaller, the result with the higher goodness of model fit is predicted. However, there is a difference between the predictive power of AIC and AICc, and previous studies have shown that using AICc to determine goodness of model fit using simulation is a method of improving accuracy. In the exemplary embodiment, a probability distribution model selected by using AICc as a key index based on a limited number of data and evidence from prior research may be applied to the PPM prediction unit 32. (Prior research: E. Song, S. Won, and W. Lee, "Using the corrected akaike's information criterion for model selection," The Korean Journal of Applied Statistics, vol. 30, no. 1, pp. 119-133, 2017.)

Like AIC, BIC may derive the best goodness of model fit based on the resulting value with the least information loss at the maximum likelihood value. The method of calculating BIC is represented in Equation 9. [equation 9] $BIC = - 2 ⋅ ln \left(L\right) + k ⋅ ln \left(n\right)$

It can be seen that Equation 9 is similar in form to Equation 7, with the difference being in the term that assigns the penalty value. Unlike AIC, the penalty in BIC increases as the value of n that is the number of data increases. Therefore, BIC may be considered as a suitable model for analyzing the distribution according to differences in data.

RMSE is also one of the statistical modeling indexes, which is calculated by squaring the value obtained by subtracting the predicted value from the actual data, adding the values all together, dividing the added value by n, and putting a root. The method of calculating RMSE is represented in Equation 10. [Equation 10] $RMSE = \sqrt{\frac{1}{n} {\sum }_{i = 1}^{n} {\left({y}_{i}-{\hat{y}}_{i}\right)}^{2}} = \sqrt{MSE}$

In Equation 10, i is a numerical value from 1 to the number n of data, yi may be defined as the i^{th} data of the actual observation value and yi may be defined as the i^{th} data of the predicted value. The value obtained by subtracting the predicted value from the actual data is called the residual, which has the same meaning as the Mean Squared Error (MSE) when squared and added together and divided by n. RMSE is a statistical modeling index used to root the MSE to give an interpretation in units similar to the actual value.

Each of the 17 probability distribution models, such as Beta, Birnbaumsaunders, Exponential, Extreme Value, Gamma, Generalized Extreme Value, Generalized Pareto, Inverseegaussian, Logistic, Loglogistic, Lognormal, Nakagami, Normal, Rayleigh, Rician, Tlocationscale, and Weibull, may be applied to a predetermined number (for example, 1,800) of capacity fades sampled based on probability weights to perform the PPM simulation. When AICc, the main index, is applied to the PPM simulation results, the three probability distribution models, Extreme Value, Generalized Extreme Value, and Weibull, showed the best goodness of model fit. Based on this, the at least one probability distribution model of the PPM prediction unit 32 according to the exemplary embodiment may be at least one of the above three.

As described above, at least one probability distribution model may be set in the PPM prediction unit 32, but the invention is not limited thereto. In contrast, the PPM simulation device 30 may determine a probability distribution model.

FIG. 4 is a diagram illustrating the PPM simulation device according to the exemplary embodiment.

As illustrated in FIG. 4, the PPM simulation device 30 may further include a probability distribution model determination unit 33.

The probability distribution model determination unit 33 may receive a plurality of probability weights and a plurality of capacity fades as input, extract a plurality of capacity fades according to the plurality of probability weights for the plurality of capacity fades, and perform the PPM simulation by applying the 17 probability distribution models described above to the plurality of extracted capacity fades.

The probability distribution model determination unit 33 may determine at least one probability distribution model by applying at least one of the previously described statistical modeling index to the results of the plurality of PPM simulations using the plurality of probability denominator models. The probability distribution model determination unit 33 may determine at least one probability distribution model based on goodness of a model fit calculated by applying statistical modeling index to the plurality of PPM simulation results. The probability distribution model determination unit 33 may transmit at least one probability distribution model to the PPM prediction unit 32.

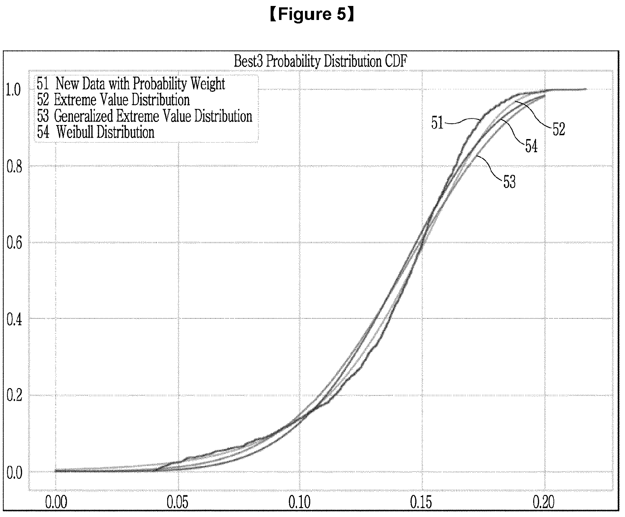

FIG. 5 is a graph illustrating a cumulative distribution function for a plurality of capacity fades and cumulative distribution functions for three probability distribution models with excellent goodness of model fit according to the exemplary embodiment.

The three probability distribution models with the excellent goodness of model fit illustrated in FIG. 5 are described as the first-order Extreme Value model, the second-order Generalized Extreme Value model, and the third-order Weibull model.

The cumulative distribution functions when the plurality of sampled capacity fades is applied to the three probability distribution models: Extreme Value model, Generalized Extreme Value model, and Weibull model are illustrated in FIG. 5. As illustrated in FIG. 5, it can be seen that the cumulative distribution function 51 of the plurality of capacity fades sampled according to probability weights and the cumulative distribution functions 52 to 54 of the three probability distribution models are similar. In FIG. 5, a cumulative distribution function for the plurality of capacity fades according to the exemplary embodiment is indicated by "51", a cumulative distribution function according to the Extreme Value model is indicated by "52", a cumulative distribution function according to the Generalized Extreme Value model is indicated by "53", and another cumulative distribution function according to the Weibull model is indicated by "54".

In this way, the accuracy of PPM predictions may be improved when PPM values are calculated by using probability distribution functions with similar goodness of model fit.

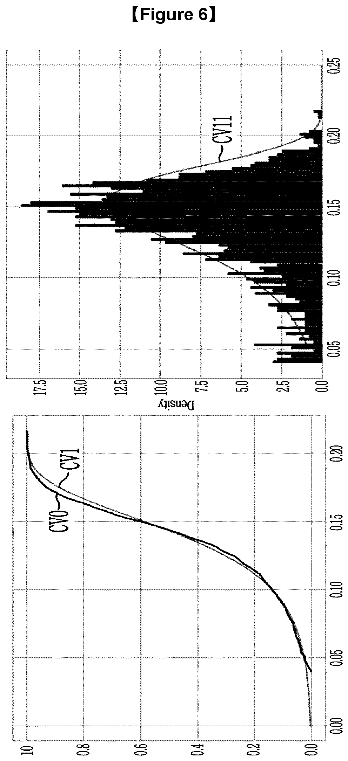

Each of FIGS. 6 to 8 is a diagram illustrating a visualization result of a cumulative distribution function and a histogram-based probability density function for three probability denominator models according to the exemplary embodiment.

As illustrated in FIG. 6, it can be seen that the goodness of fit between the curve CV1 representing the cumulative distribution function resulting from the application of the plurality of capacity fades (hereinafter, referred to as sample data) obtained by a single extraction based on probability weights to the Extreme Value Distribution model and the curve CV0 representing the cumulative distribution function of the sample data is very high. Further, I can be seen that the curve CV11, which represents the histogram-based probability density function for the sample data, is balanced.

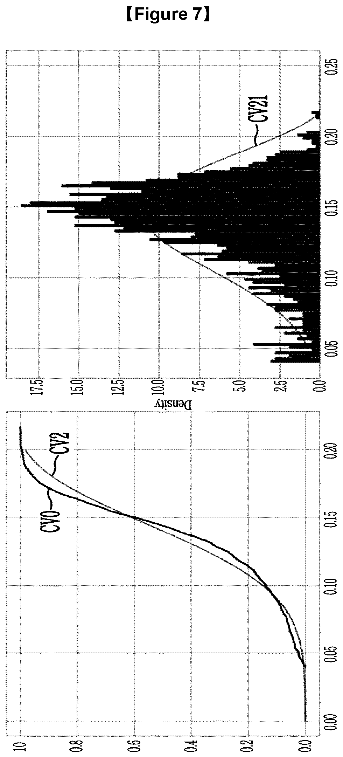

As illustrated in FIG. 7, the goodness of fit between the curve CV2 representing the cumulative distribution function resulting from the application of the sample data to the Generalized Extreme Value Distribution model and the curve CV0 representing the cumulative distribution function of the sample data is also high. It can be seen that the curve CV21 representing the probability density function is also balanced, has the form with a lower peak and a wider spread from side to side compared to the curve CV11 in FIG. 6.

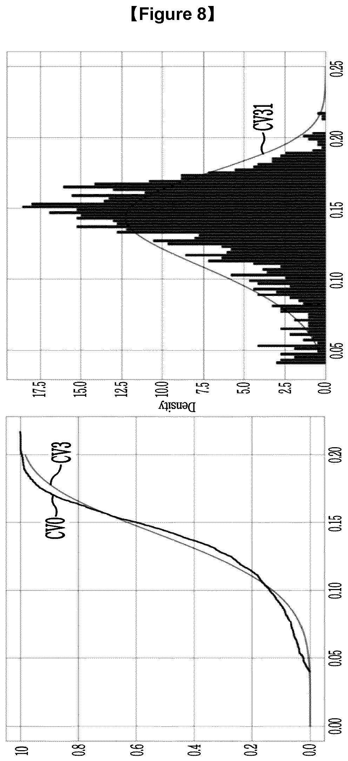

As illustrated in FIG. 8, the goodness of fit between the curve CV3 representing the cumulative distribution function resulting from the application of the sample data to the Weibull Distribution model and the curve CV0 representing the cumulative distribution function of the sample data is also high. The curve CV31 representing the probability density function has a lower peak and a rightward sloping shape compared to the curve CV11 in FIG. 6.

In the cumulative distribution function and the probability density function, the x-axis is a probability variable and is the capacity fade, and the y-axis value of the cumulative distribution function describes the cumulative probability and the y-axis value of the probability density function describes the probability density. When the threshold for capacity fade is 0.3 (30%), there is a possibility that the PPM value that is not seen in the probability density function in FIGS. 7 and 8 and in the sample data occur in the probability density function in FIG. 8.

The PPM predicting unit 32 may apply the three probability distribution models described above to the plurality of capacity fades derived through bootstrapping based on probability weights to calculate a PPM value.

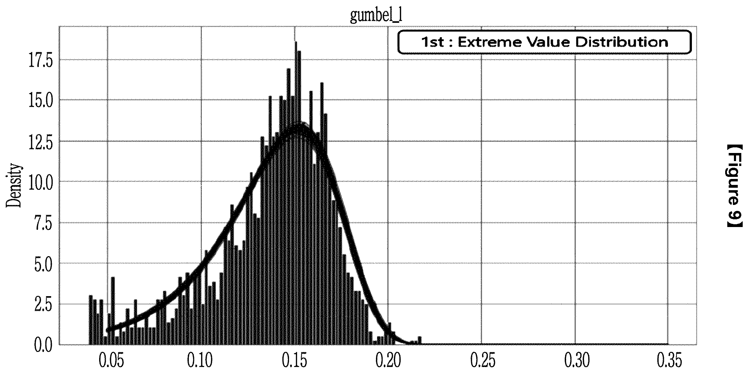

FIGS. 9 to 11 are diagram illustrating the results of applying three probability denominator models to the plurality of capacity fades derived from bootstrapping based on probability weights.

The PPM predicting unit 32 may perform bootstrapping based on probability weights 30 times to extract the 1800 capacity fades 30 times, organizes the results of applying the 1800 capacity fades extracted each time to each of the Extreme Value Distribution model, the Generalized Extreme Value Distribution model, and the Weibull Distribution model into a histogram, and generate a probability density function based on the histogram.

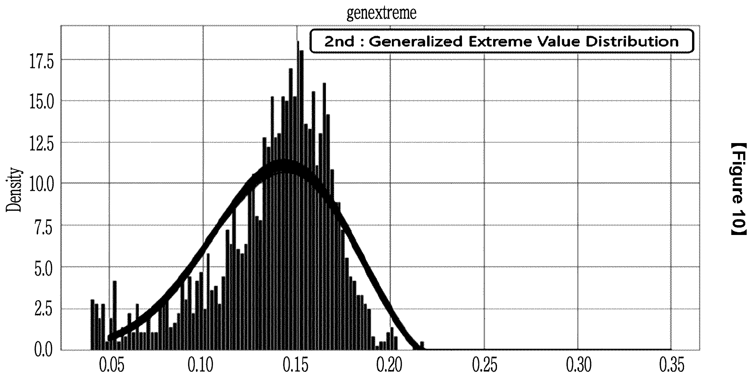

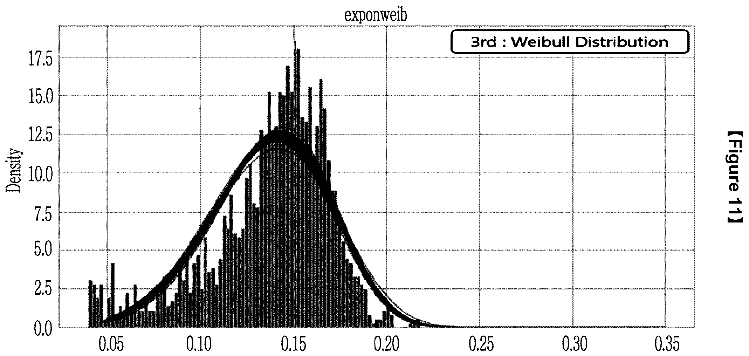

FIG. 9 illustrates the histogram and the probability density function under the Extreme Value Distribution model for the capacity fades derived by 30-times bootstrapping. FIG. 10 illustrates the histogram and the probability density function under the Generalized Extreme Value Distribution model for the capacity fades derived by 30-times bootstrapping. FIG. 11 illustrates the histogram and the probability density function under the Weibull Distribution model for the capacity fades derived by 30-times bootstrapping. In FIGS. 9 to 11, 30 curves representing the probability density functions for the respective 30-times bootstrapping are illustrated. As can be seen from FIGS. 9 to 11, it can be seen that there is a fluctuation in the data for capacity fade. That is, the data range for the capacity fade is formed, so that the accuracy of PPM prediction may be improved.

The PPM predicting unit 32 may calculate a PPM value by summing the values for which the capacity fade exceeds a threshold (for example, 30%), within a 75% (12.5 % to 87.5%) confidence interval of the plurality of probability density function curve illustrated in each of FIGS. 9 to 11.

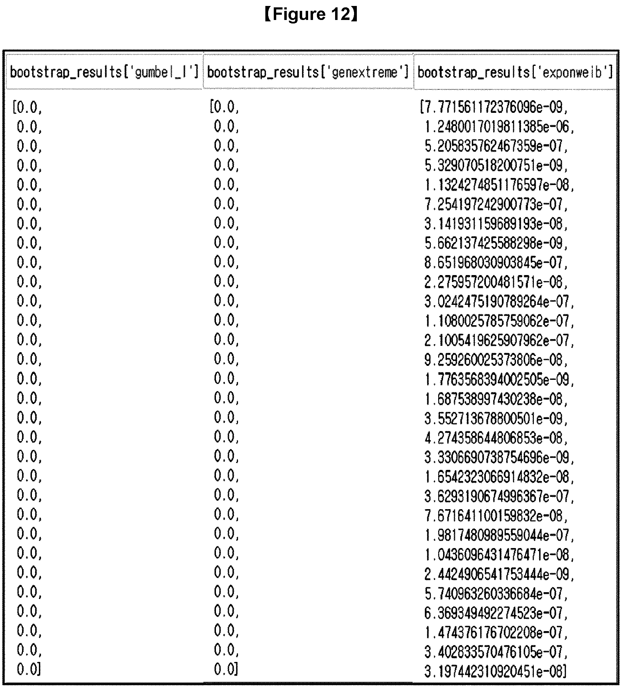

FIG. 12 is a table representing the PPM values for each model derived for each bootstrapping count.

As illustrated in FIG. 12, 30 PPM values are zero, which is the result of 30-times bootstrapping based on the probability distribution models Extreme Value Distribution (gumbel_l in FIG. 12) and Generalized Extreme Value Distribution (genextreme in FIG. 12) among Extreme Value Distribution, Generalized Extreme Value Distribution, and Weibull Distribution. In contrast, the 30 PPM values, which are the results of 30-times bootstrapping based on the probability distribution model Weibull Distribution (exponweib in FIG. 12), range from a minimum of 0.0000000047 to a maximum of 0.0000006. Thus, the PPM predicting unit 32 may sum the 30 PPM values generated based on the Weibull Distribution model to calculate a final PPM value.

In this way, the PPM simulation device according to the exemplary embodiment may obtain a variety of data as the battery capacity fade data that is the input data is plotted as a continuous, smoothed cumulative distribution function. Further, it is possible to achieve goodness of model fit with a probability distribution model group that is not overfitted. Bootstrapping is performed based on probability weights, so it is possible to calculate PPM results that reflect the volatility of the battery.

In the exemplary embodiment, it is possible to overcome conditions where the goodness of fit of the probability distribution is uncertain and there are insufficient samples extracted from the population by using bootstrapping. Through this, it is possible to solve the problem in that it is difficult to obtain long-term driving data based on actual various driving types. Life analysis simulations based on short-term battery charge and discharge cycle data models inevitably generate limited fade prediction data. According to the exemplary embodiment, an extended driving profile including the combination of driving profiles is generated, thereby obtaining a variety of driving profiles. This overcomes the limitation of simply iteratively amplifying a limited number of fade prediction data and predicting PPM values by using the amplified data.

Further, according to the exemplary embodiment, an appropriate probability distribution model is selected from a plurality of probability distribution models through a statistical modeling index, thereby solving the problem of overfitting PPM prediction results. In addition, by performing bootstrapping using probability weights, the diversity of the sample data may be improved.

## Claims

1. An apparatus for predicting a failure rate of an electric vehicle battery, the apparatus comprising:
a data generation device (10) for restoring and extracting at least two driving profiles by allowing duplication among a plurality of driving profiles configuring original data, generating a plurality of extended driving profiles by combining the at least two extracted driving profiles, and generating a plurality of extended weights corresponding to the plurality of extended driving profiles;
an aging simulation device (20) for generating a plurality of capacity fades by performing a life analysis simulation to which a plurality of climate conditions are applied on the plurality of extended driving profiles; and
a PPM simulation device (30) for generating a plurality of probability weights based on the plurality of extended weights and weights corresponding to the plurality of climate conditions, and for calculating a PPM value by assigning the plurality of probability weights to the plurality of capacity fades.

2. The apparatus of claim 1, wherein:
the aging simulation device (20) includes:
an ECM module (21) for applying each of the plurality of extended driving profiles to an electrical Equivalent Circuit Model, ECM, for a battery subject to an aging simulation to generate a voltage, a current, an SOC, a C-rate, and an amount of heating of the battery corresponding to each of the extended driving profiles;
a thermal model module (22) for generating an average temperature of a battery by using the amount of heating of the corresponding battery and a temperature of each of the extended driving profiles, for each of the plurality of extended driving profiles; and
an aging model module for calculating a capacity fade of the battery based on the voltage, the current, the SOC, the C-rate, a driving mode, an average temperature, and the number of cells of the corresponding battery, for each of the plurality of extended driving profiles.

3. The apparatus of claim 2, wherein:
the aging model module
calculates a capacity fade based on a cycle degradation due to a driving pattern by discharging and charging due to driving in the driving mode or based on a calendar degradation due to a rest state of the battery in the driving mode.

4. The apparatus of claim 1, wherein:
the PPM simulation device (30)
assigns, for each of the plurality of capacity fades, a corresponding probability weight among the plurality of probability weights, bootstraps based on the plurality of probability weights assigned to the plurality of capacity fades, and calculates a PPM value for sample data extracted by the bootstrapping.

5. The apparatus of claim 4, wherein:
the PPM simulation device includes
a probability weight generation unit for generating the plurality of probability weights by using a result of multiplying the plurality of extended weights and a weight of each of the plurality of climate conditions.

6. The apparatus of claim 5, wherein:
the probability weight generation unit
multiplies the plurality of extended weights by the weight of each of the plurality of climate conditions to generate a plurality of composite weights, and
for each of the plurality of climate conditions, calculates a weight sum by adding all of the plurality of composite weights belonging to each climate condition, and calculates a probability weight by dividing each of the plurality of composite weights belonging to each climate condition by the weight sum.

7. The apparatus of claim 4, wherein:
the PPM simulation device (30) includes
a PPM derivation unit that assigns each of the plurality of probability weights to a corresponding capacity fade among the plurality of capacity fades, and repeats bootstrapping a predetermined number of times to restore and extract a predetermined number of capacity fades among the plurality of capacity fades based on the plurality of probability weights assigned to the plurality of capacity fades.

8. The apparatus of claim 7, wherein:
the PPM derivation unit
calculates a PPM value by applying at least one probability distribution model to the predetermined number of capacity fades extracted from each bootstrapping, and generates a final PPM value by adding PPM values derived from the predetermined number of times of the bootstrapping.

9. The apparatus of claim 4, wherein:
the PPM simulation device (30)
extracts a plurality of capacity fades based on the plurality of probability weights for the plurality of capacity fades, performs a plurality of PPM simulations by applying a plurality of probability distribution models to the plurality of extracted capacity fades, and determines at least one probability distribution model by applying at least one statistical modeling index to the plurality of PPM simulation results.

10. A method of predicting a failure rate of an electric vehicle battery, the method comprising:
restoring and extracting at least two driving profiles by allowing duplication among a plurality of driving profiles configuring original data, and generating a plurality of extended driving profiles by combining the at least two extracted driving profiles;
generating a plurality of extended weights corresponding to the plurality of extended driving profiles;
generating a plurality of capacity fades by performing a life analysis simulation to which a plurality of climate conditions are applied on the plurality of extended driving profiles;
generating a plurality of probability weights based on the plurality of extended weights and weights corresponding to the plurality of climate conditions; and
calculating a final PPM value by assigning the plurality of probability weights to the plurality of capacity fades.

11. The method of claim 10, wherein:
the calculating of the final PPM value includes:
assigning, for each of the plurality of capacity fades, a corresponding probability weight among the plurality of probability weights;
bootstrapping based on the plurality of probability weights assigned to the plurality of capacity fades; and
calculating a PPM value for sample data extracted by the bootstrapping.

12. The method of claim 11, wherein:
the bootstrapping includes
restoring and extracting a predetermined number of capacity fades among the plurality of capacity fades based on the plurality of probability weights assigned to the plurality of capacity fades.

13. The method of claim 12, wherein:
the calculating of the PPM value includes
calculating a PPM value by applying at least one probability distribution model to the predetermined number of capacity fades extracted from the bootstrapping.

14. The method of claim 11, wherein:
the calculating of the final PPM value further includes
generating a final PPM value by adding PPM values derived from the predetermined number of times of bootstrapping.

15. The method of claim 10, wherein:
the generating of the plurality of probability weights includes:
multiplying the plurality of extended weights by the weight of each of the plurality of climate conditions to generate a plurality of composite weights;
for each of the plurality of climate conditions, calculating a weight sum by adding all of the plurality of composite weights belonging to each climate condition; and
calculating a probability weight by dividing each of the plurality of composite weights belonging to each climate condition by the weight sum.

16. The method of claim 10, further comprising:
extracting a plurality of capacity fades based on the plurality of probability weights for the plurality of capacity fades;
performing a plurality of PPM simulations by applying a plurality of probability distribution models to the plurality of extracted capacity fades; and
determining at least one probability distribution model by applying at least one statistical modeling index to the plurality of PPM simulation results.

## Patentansprüche

1. Vorrichtung zum Vorhersagen einer Ausfallrate einer Elektrofahrzeugbatterie, wobei die Vorrichtung umfasst:
eine Datenerzeugungsvorrichtung (10) zum Wiederherstellen und Extrahieren von mindestens zwei Fahrprofilen durch Ermöglichen einer Duplizierung unter einer Vielzahl von Fahrprofilen, die Originaldaten konfigurieren, Erzeugen einer Vielzahl von erweiterten Fahrprofilen durch Kombinieren der mindestens zwei extrahierten Fahrprofile und Erzeugen einer Vielzahl von erweiterten Gewichtungen, die der Vielzahl von erweiterten Fahrprofilen entsprechen;
eine Alterungssimulationsvorrichtung (20) zum Erzeugen einer Vielzahl von Kapazitätsverwürfen durch Durchführen einer Lebensanalysesimulation, auf die eine Vielzahl von Klimabedingungen auf die Vielzahl von erweiterten Fahrprofilen angewendet wird; und
eine PPM-Simulationsvorrichtung (30) zum Erzeugen einer Vielzahl von Wahrscheinlichkeitsgewichtungen basierend auf der Vielzahl von erweiterten Gewichtungen und Gewichtungen, die der Vielzahl von Klimabedingungen entsprechen, und zum Berechnen eines PPM-Werts durch Zuweisen der Vielzahl von Wahrscheinlichkeitsgewichtungen zu der Vielzahl von Kapazitätsverwürfen.

2. Vorrichtung nach Anspruch 1, wobei:
die Alterungssimulationsvorrichtung (20) einschließt:
ein ECM-Modul (21) zum Anwenden jedes der Vielzahl von erweiterten Fahrprofilen auf ein elektrisches Ersatzschaltungsmodell, ECM, für eine Batterie, die einer Alterungssimulation unterzogen wird, um eine Spannung, einen Strom, einen SOC, eine C-Rate und eine Heizmenge der Batterie zu erzeugen, die jedem der erweiterten Fahrprofile entsprechen;
ein Wärmemodellmodul (22) zum Erzeugen einer Durchschnittstemperatur einer Batterie unter Verwendung der Heizmenge der entsprechenden Batterie und einer Temperatur jedes der erweiterten Fahrprofile für jedes der Vielzahl von erweiterten Fahrprofilen; und
ein Alterungsmodellmodul zum Berechnen eines Kapazitätsverwurfs der Batterie basierend auf der Spannung, dem Strom, dem SOC, der C-Rate, einem Fahrmodus, einer Durchschnittstemperatur und der Anzahl von Zellen der entsprechenden Batterie für jedes der Vielzahl von erweiterten Fahrprofilen.

3. Vorrichtung nach Anspruch 2, wobei:
das Alterungsmodellmodul
einen Kapazitätsverwurf basierend auf einer Zyklusverschlechterung aufgrund eines Fahrmusters durch Entladen und Laden aufgrund des Fahrens im Fahrmodus oder basierend auf einer Kalenderverschlechterung aufgrund eines Ruhezustands der Batterie im Fahrmodus berechnet.

4. Vorrichtung nach Anspruch 1, wobei:
die PPM-Simulationsvorrichtung (30)
für jeden der Vielzahl von Kapazitätsverwürfen eine entsprechende Wahrscheinlichkeitsgewichtung unter der Vielzahl von Wahrscheinlichkeitsgewichtungen zuweist, Bootstrapping basierend auf der Vielzahl von Wahrscheinlichkeitsgewichtungen, die der Vielzahl von Kapazitätsverwürfen zugewiesen sind, und einen PPM-Wert für durch das Bootstrapping extrahierte Probendaten berechnet.

5. Vorrichtung nach Anspruch 4, wobei:
die PPM-Simulationsvorrichtung einschließt
eine Wahrscheinlichkeitsgewichtungserzeugungseinheit zum Erzeugen der Vielzahl von Wahrscheinlichkeitsgewichtungen unter Verwendung eines Ergebnisses des Multiplizierens der Vielzahl von erweiterten Gewichtungen und einer Gewichtung jeder der Vielzahl von Klimabedingungen.

6. Vorrichtung nach Anspruch 5, wobei:
die Wahrscheinlichkeitsgewichtungserzeugungseinheit
die Vielzahl von erweiterten Gewichtungen mit der Gewichtung jeder der Vielzahl von Klimabedingungen multipliziert, um eine Vielzahl von zusammengesetzten Gewichtungen zu erzeugen, und
für jede der Vielzahl von Klimabedingungen eine Gewichtungssumme durch Addieren aller der Vielzahl von zusammengesetzten Gewichtungen, die zu jeder Klimabedingung gehören, berechnet und eine Wahrscheinlichkeitsgewichtung durch Dividieren jeder der Vielzahl von zusammengesetzten Gewichtungen, die zu jeder Klimabedingung gehören, durch die Gewichtungssumme berechnet.

7. Vorrichtung nach Anspruch 4, wobei:
die PPM-Simulationsvorrichtung (30) einschließt
eine PPM-Ableitungseinheit, die jede der Vielzahl von Wahrscheinlichkeitsgewichtungen einem entsprechenden Kapazitätsverwurf unter der Vielzahl von Kapazitätsverwürfen zuweist und Bootstrapping eine vorbestimmte Anzahl von Malen wiederholt, um eine vorbestimmte Anzahl von Kapazitätsverwürfen unter der Vielzahl von Kapazitätsverwürfen basierend auf der Vielzahl von Wahrscheinlichkeitsgewichtungen, die der Vielzahl von Kapazitätsverwürfen zugewiesen sind, wiederherzustellen und zu extrahieren.

8. Vorrichtung nach Anspruch 7, wobei:
die PPM-Ableitungseinheit
einen PPM-Wert berechnet, indem mindestens ein Wahrscheinlichkeitsverteilungsmodell auf die vorbestimmte Anzahl von Kapazitätsverwürfen angewendet wird, die aus jedem Bootstrapping extrahiert werden, und einen endgültigen PPM-Wert erzeugt, indem PPM-Werte addiert werden, die aus der vorbestimmten Anzahl von Malen des Bootstrapping abgeleitet werden.

9. Vorrichtung nach Anspruch 4, wobei:
die PPM-Simulationsvorrichtung (30)
eine Vielzahl von Kapazitätsverwürfen basierend auf der Vielzahl von Wahrscheinlichkeitsgewichtungen für die Vielzahl von Kapazitätsverwürfen extrahiert, eine Vielzahl von PPM-Simulationen durchführt, indem eine Vielzahl von Wahrscheinlichkeitsverteilungsmodellen auf die Vielzahl von extrahierten Kapazitätsverwürfen angewendet wird, und mindestens ein Wahrscheinlichkeitsverteilungsmodell bestimmt, indem mindestens ein statistischer Modellierungsindex auf die Vielzahl von PPM-Simulationsergebnissen angewendet wird.

10. Verfahren zum Vorhersagen einer Ausfallrate einer Elektrofahrzeugbatterie, wobei das Verfahren umfasst:
Wiederherstellen und Extrahieren von mindestens zwei Fahrprofilen durch Ermöglichen einer Duplizierung unter einer Vielzahl von Fahrprofilen, die Originaldaten konfigurieren, und Erzeugen einer Vielzahl von erweiterten Fahrprofilen durch Kombinieren der mindestens zwei extrahierten Fahrprofile;
Erzeugen einer Vielzahl von erweiterten Gewichtungen, die der Vielzahl von erweiterten Fahrprofilen entsprechen;
Erzeugen einer Vielzahl von Kapazitätsverwürfen durch Durchführen einer Lebensanalysesimulation, auf die eine Vielzahl von Klimabedingungen auf die Vielzahl von erweiterten Fahrprofilen angewendet wird;
Erzeugen einer Vielzahl von Wahrscheinlichkeitsgewichtungen basierend auf der Vielzahl von erweiterten Gewichtungen und Gewichtungen, die der Vielzahl von Klimabedingungen entsprechen; und
Berechnen eines endgültigen PPM-Werts durch Zuweisen der Vielzahl von Wahrscheinlichkeitsgewichtungen zu der Vielzahl von Kapazitätsverwürfen.

11. Verfahren nach Anspruch 10, wobei:
das Berechnen des endgültigen PPM-Werts einschließt:
Zuweisen, für jeden der Vielzahl von Kapazitätsverwürfen, einer entsprechenden Wahrscheinlichkeitsgewichtung unter der Vielzahl von Wahrscheinlichkeitsgewichtungen;
Bootstrapping basierend auf der Vielzahl von Wahrscheinlichkeitsgewichtungen, die der Vielzahl von Kapazitätsverwürfen zugewiesen sind; und
Berechnen eines PPM-Werts für durch das Bootstrapping extrahierte Probendaten.

12. Verfahren nach Anspruch 11, wobei:
das Bootstrapping einschließt
Wiederherstellen und Extrahieren einer vorbestimmten Anzahl von Kapazitätsverwürfen unter der Vielzahl von Kapazitätsverwürfen basierend auf der Vielzahl von Wahrscheinlichkeitsgewichtungen, die der Vielzahl von Kapazitätsverwürfen zugewiesen sind.

13. Verfahren nach Anspruch 12, wobei:
das Berechnen des PPM-Werts einschließt
Berechnen eines PPM-Werts durch Anwenden mindestens eines Wahrscheinlichkeitsverteilungsmodells auf die vorbestimmte Anzahl von Kapazitätsverwürfen, die aus dem Bootstrapping extrahiert werden.

14. Verfahren nach Anspruch 11, wobei:
das Berechnen des endgültigen PPM-Werts ferner einschließt
Erzeugen eines endgültigen PPM-Werts durch Addieren von PPM-Werten, die aus der vorbestimmten Anzahl von Malen des Bootstrapping abgeleitet werden.

15. Verfahren nach Anspruch 10, wobei:
das Erzeugen der Vielzahl von Wahrscheinlichkeitsgewichtungen einschließt:
Multiplizieren der Vielzahl von erweiterten Gewichtungen mit der Gewichtung jeder der Vielzahl von Klimabedingungen, um eine Vielzahl von zusammengesetzten Gewichtungen zu erzeugen;
für jede der Vielzahl von Klimabedingungen, Berechnen einer Gewichtungssumme durch Addieren aller der Vielzahl von zusammengesetzten Gewichtungen, die zu jeder Klimabedingung gehören; und
Berechnen einer Wahrscheinlichkeitsgewichtung durch Dividieren jeder der Vielzahl von zusammengesetzten Gewichtungen, die zu jeder Klimabedingung gehören, durch die Gewichtungssumme.

16. Verfahren nach Anspruch 10, ferner umfassend:
Extrahieren einer Vielzahl von Kapazitätsverwürfen basierend auf der Vielzahl von Wahrscheinlichkeitsgewichtungen für die Vielzahl von Kapazitätsverwürfen;
Durchführen einer Vielzahl von PPM-Simulationen durch Anwenden einer Vielzahl von Wahrscheinlichkeitsverteilungsmodellen auf die Vielzahl von extrahierten Kapazitätsverwürfen; und
Bestimmen mindestens eines Wahrscheinlichkeitsverteilungsmodells durch Anwenden mindestens eines statistischen Modellierungsindex auf die Vielzahl von PPM-Simulationsergebnissen.

## Revendications

1. Appareil servant à prédire un taux de défaillance d'une batterie de véhicule électrique, l'appareil comportant :
un dispositif de génération de données (10) servant à restaurer et à extraire au moins deux profils de conduite en permettant la duplication parmi une pluralité de profils de conduite configurant des données originales, à générer une pluralité de profils de conduite étendus en combinant lesdits au moins deux profils de conduite extraits, et à générer une pluralité de poids étendus correspondant à la pluralité de profils de conduite étendus ;
un dispositif de simulation de vieillissement (20) servant à générer une pluralité d'évanouissements de capacité en réalisant une simulation d'analyse du cycle de vie selon laquelle les conditions d'une pluralité de conditions climatiques sont appliquées à la pluralité de profils de conduite étendus ; et
un dispositif de simulation PPM (30) servant à générer une pluralité de poids de probabilité sur la base de la pluralité de poids étendus et de poids correspondant à la pluralité de conditions climatiques, et servant à calculer une valeur PPM en attribuant la pluralité de poids de probabilité à la pluralité d'évanouissements de capacité.

2. Appareil selon la revendication 1, dans lequel :
le dispositif de simulation de vieillissement (20) comprend :
un module ECM (21) servant à appliquer chaque profil de la pluralité de profils de conduite étendus à un modèle de circuit équivalent électrique, ECM, pour une batterie soumise à une simulation de vieillissement afin de générer une tension, un courant, un état de charge SOC, un taux de charge/décharge C et une quantité de chauffage de la batterie correspondant à chacun des profils de conduite étendus ;
un module de modèle thermique (22) servant à générer une température moyenne d'une batterie en utilisant la quantité de chauffage de la batterie correspondante et une température de chacun des profils de conduite étendus, pour chaque profil de la pluralité de profils de conduite étendus ; et
un module de modèle de vieillissement servant à calculer un évanouissement de capacité de la batterie sur la base de la tension, du courant, de l'état de charge SOC, du taux de charge/décharge C, d'un mode de conduite, d'une température moyenne, et du nombre d'éléments de la batterie correspondante, pour chaque profil de la pluralité de profils de conduite étendus.

3. Appareil selon la revendication 2, dans lequel :
le module de modèle de vieillissement
calcule un évanouissement de capacité sur la base d'une dégradation du cycle due à un modèle de conduite par décharge et charge due à la conduite en mode de conduite ou sur la base d'une dégradation calendaire due à un état de repos de la batterie en mode de conduite.

4. Appareil selon la revendication 1, dans lequel :
le dispositif de simulation PPM (30)
attribue, pour chaque évanouissement de la pluralité d'évanouissements de capacité, un poids de probabilité correspondant parmi la pluralité de poids de probabilité, effectue un amorçage sur la base de la pluralité de poids de probabilité attribués à la pluralité d'évanouissements de capacité, et calcule une valeur PPM pour des données d'échantillons extraites par l'amorçage.

5. Appareil selon la revendication 4, dans lequel :
le dispositif de simulation PPM comprend
une unité de génération de poids de probabilité servant à générer la pluralité de poids de probabilité en utilisant un résultat issu d'une multiplication de la pluralité de poids étendus par un poids de chaque condition de la pluralité de conditions climatiques.

6. Appareil selon la revendication 5, dans lequel :
l'unité de génération de poids de probabilité
multiplie la pluralité de poids étendus par le poids de chaque condition de la pluralité de conditions climatiques afin de générer une pluralité de poids composites, et
pour chaque condition de la pluralité de conditions climatiques, calcule une somme de poids en additionnant tous les poids de la pluralité de poids composites appartenant à chaque condition climatique, et calcule un poids de probabilité en divisant chaque poids de la pluralité de poids composites appartenant à chaque condition climatique par la somme des poids.

7. Appareil selon la revendication 4, dans lequel :
le dispositif de simulation PPM (30) comprend
une unité de dérivation PPM qui attribue chaque poids de la pluralité de poids de probabilité à un évanouissement de capacité correspondant parmi la pluralité d'évanouissements de capacité, et répète l'amorçage un nombre prédéterminé de fois pour restaurer et extraire un nombre prédéterminé d'évanouissements de capacité parmi la pluralité d'évanouissements de capacité sur la base de la pluralité de poids de probabilité attribués à la pluralité d'évanouissements de capacité.

8. Appareil selon la revendication 7, dans lequel :
l'unité de dérivation PPM
calcule une valeur PPM en appliquant au moins un modèle de distribution de probabilité au nombre prédéterminé d'évanouissements de capacité extraits de chaque amorçage, et génère une valeur PPM finale en additionnant des valeurs PPM dérivées en provenance du nombre prédéterminé de fois de l'amorçage.

9. Appareil selon la revendication 4, dans lequel :
le dispositif de simulation PPM (30)
extrait une pluralité d'évanouissements de capacité sur la base de la pluralité de poids de probabilité pour la pluralité d'évanouissements de capacité, effectue une pluralité de simulations PPM en appliquant une pluralité de modèles de distribution de probabilité à la pluralité d'évanouissements de capacité extraits, et détermine au moins un modèle de distribution de probabilité en appliquant au moins un indice de modélisation statistique à la pluralité de résultats de simulation PPM.

10. Procédé servant à prédire un taux de défaillance d'une batterie de véhicule électrique, le procédé comportant les étapes consistant à :
restaurer et extraire au moins deux profils de conduite en permettant la duplication parmi une pluralité de profils de conduite configurant des données originales, et générer une pluralité de profils de conduite étendus en combinant lesdits au moins deux profils de conduite extraits ;
générer une pluralité de poids étendus correspondant à la pluralité de profils de conduite étendus ;
générer une pluralité d'évanouissements de capacité en réalisant une simulation d'analyse du cycle de vie selon laquelle les conditions d'une pluralité de conditions climatiques sont appliquées à la pluralité de profils de conduite étendus ;
générer une pluralité de poids de probabilité sur la base de la pluralité de poids étendus et de poids correspondant à la pluralité de conditions climatiques ; et
calculer une valeur PPM finale en attribuant la pluralité de poids de probabilité à la pluralité d'évanouissements de capacité.

11. Procédé selon la revendication 10, dans lequel :
l'étape consistant à calculer la valeur PPM finale comprend les étapes consistant à :
attribuer, pour chaque évanouissement de la pluralité d'évanouissements de capacité, un poids de probabilité correspondant parmi la pluralité de poids de probabilité ;
amorcer sur la base de la pluralité de poids de probabilité attribués à la pluralité d'évanouissements de capacité ; et
calculer une valeur PPM pour des données d'échantillons extraites par l'amorçage.

12. Procédé selon la revendication 11, dans lequel :
l'étape consistant à amorcer comprend les étapes consistant à
restaurer et extraire un nombre prédéterminé d'évanouissements de capacité parmi la pluralité d'évanouissements de capacité sur la base de la pluralité de poids de probabilité attribués à la pluralité d'évanouissements de capacité.

13. Procédé selon la revendication 12, dans lequel :
l'étape consistant à calculer la valeur PPM comprend l'étape consistant à
calculer une valeur PPM en appliquant au moins un modèle de distribution de probabilité au nombre prédéterminé d'évanouissements de capacité extraits de l'amorçage.

14. Procédé selon la revendication 11, dans lequel :
l'étape consistant à calculer la valeur PPM finale comprend par ailleurs l'étape consistant à
générer une valeur PPM finale en additionnant des valeurs PPM dérivées en provenance du nombre prédéterminé de fois de l'amorçage.

15. Procédé selon la revendication 10, dans lequel :
l'étape consistant à générer la pluralité de poids de probabilité comprend les étapes consistant à :
multiplier la pluralité de poids étendus par le poids de chaque condition de la pluralité de conditions climatiques afin de générer une pluralité de poids composites ;
pour chaque condition de la pluralité de conditions climatiques, calculer une somme de poids en additionnant tous les poids de la pluralité de poids composites appartenant à chaque condition climatique ; et
calculer un poids de probabilité en divisant chaque poids de la pluralité de poids composites appartenant à chaque condition climatique par la somme des poids.

16. Procédé selon la revendication 10, comportant par ailleurs les étape consistant à :
extraire une pluralité d'évanouissements de capacité sur la base de la pluralité de poids de probabilité pour la pluralité d'évanouissements de capacité ;
effectuer une pluralité de simulations PPM en appliquant une pluralité de modèles de distribution de probabilité à la pluralité d'évanouissements de capacité extraits ; et
déterminer au moins un modèle de distribution de probabilité en appliquant au moins un indice de modélisation statistique à la pluralité de résultats de simulation PPM.
